# EUROPEAN PATENT APPLICATION

(11) **EP 4 819 136 A1**
(43) Date of publication of application: **07.10.2026**
(21) Application number: 26165395.0
(22) Date of filing: 17.03.2026
(51) Int. Cl.: G11C 7/10, G11C 13/00

(54) **IN-MEMORY COMPUTATION DEVICE HAVING AN ANALOG COMPENSATION AND METHOD**

(30) Priority: 04.04.2025 IT 202500007254
(71) Applicant: STMicroelectronics International N.V., 1228 Plan-les-Ouates, Geneva (CH)
(72) Inventor: BERTOLINI AGNOLETTO, Jacopo John, 20864 AGRATE BRIANZA (MB) (IT); ZURLA, Riccardo, 20864 AGRATE BRIANZA (MB) (IT); CALVETTI, Emanuela, 20864 AGRATE BRIANZA (MB) (IT); PASOTTI, Marco, 20864 AGRATE BRIANZA (MB) (IT)
(74) Representative: Studio Torta S.p.A.

(57) **Abstract**

An in-memory computation device has: a word line activation circuit that receives input values and, in response, provides activation signals to word lines, as a function of the plurality of input values; a bias circuit that provides a corrected bias voltage to a bit line; and a memory array with memory cells couplable to the bit line and each to a word line. The memory cells are configured to be traversed by cell current that is a function of the bias voltage, an activation signal, and a computational weight. The bit line is configured to be traversed by a bit line current that is a function of a sum of the cell currents. A detection circuit provides, as a function of the bit line current, an output signal indicative of charge flowed in the bit line. The bias voltage is a function of a common bias signal and a calibration factor that is determined during a calibration step and is representative of an error between an actual computational result and an ideal computational result of the calibration step.

## Description

### Technical Field

The present invention relates to an in-memory computation (IMC) device having analog compensation. Furthermore, the invention also refers to a related method of controlling the IMC device and to a method of calibrating the IMC device.

### Background

As is known, an in-memory computation device (hereinafter IMC device) uses the specific arrangement of the memory cells of a memory array to perform analog data processing.

For example, IMC devices are used to perform multiply and accumulate (MAC) operations, which are for example employed to implement machine learning algorithms, such as for example neural networks.

A multiply and accumulate operation provides an output vector Y=y₁, ..., y_{M} as a result of the multiplication of an input vector X=x₁,..., x_{N} by a vector or matrix of computational weights G, for example: $\left[\begin{matrix}{y}_{1} \\ {y}_{2} \\ ⋮ \\ {y}_{M}\end{matrix}\right] = \left[\begin{matrix}{g}_{11} & {g}_{12} & … & {g}_{1 N} \\ {g}_{21} & {g}_{22} & … & {g}_{2 N} \\ ⋮ & ⋮ & ⋮ & ⋮ \\ {g}_{M 1} & {g}_{M 2} & … & {g}_{MN}\end{matrix}\right] \times \left[\begin{matrix}{x}_{1} \\ {x}_{2} \\ ⋮ \\ {x}_{N}\end{matrix}\right] ,$ i.e. : $\left\{\begin{matrix}{y}_{1} = {g}_{11} ⋅ {x}_{1} + {g}_{12} ⋅ {x}_{2} + ⋯ + {g}_{1 N} ⋅ {x}_{N} \\ {y}_{2} = {g}_{21} ⋅ {x}_{1} + {g}_{22} ⋅ {x}_{2} + ⋯ + {g}_{2 N} ⋅ {x}_{N} \\ ⋮ \\ {y}_{M} = {g}_{M 1} ⋅ {x}_{1} + {g}_{M 2} ⋅ {x}_{2} + ⋯ + {g}_{MN} ⋅ {x}_{N}\end{matrix}\right. .$

The IMC device stores the computational weights gᵢⱼ in the memory cells and performs the multiplication and sum operations at cell level.

In detail, for each value yᵢ of the output vector Y the known IMC devices generate a current indicative of a respective MAC operation, i.e. ${y}_{i} = {\sum }_{j = 1}^{N} {g}_{ij} ⋅ {x}_{j}$, and comprise a read circuit having a respective analog-to-digital converter (ADC) which discretizes said current.

IMC devices allow the back and forth transfer of data between a memory and a processing unit to be avoided. Consequently, the performance of an IMC device is not limited by the data transfer bandwidth between memory and processing unit and has low power consumption.

The computational weights are stored in the memory array as conductance values of the memory cells.

However, the conductance value stored in the memory cells is subject to variations over time, for example due to drift phenomena, temperature variations of the IMC device, voltage variations and other error sources.

The variations in the conductance values over time cause the stored computational weight to deviate from the programmed nominal value. Thus, the output signal yᵢ provided during the execution of an in-memory operation also deviates from the nominal correct result of the computation.

According to an approach, the output signal yᵢ, that is indicative of the charge flowed in the bit line BLᵢ during the execution of the in-memory operation, may be multiplied by a calibration factor. The calibration factor may have been measured during a calibration step of the in-memory device.

However, the multiplication of the output signal yᵢ is a digital operation that may require both a high area occupation and a high power consumption.

The aim of the present invention is to overcome the disadvantages of the prior art.

### Summary

According to the present invention, an in-memory computation device, a control method and a calibration method are therefore provided, as defined in the appended claims.

### Brief Description of the Drawings

For a better understanding of the present invention, embodiments thereof are now described, purely by way of nonlimiting example, with reference to the attached drawings, wherein:
- Figure 1 shows a block diagram of an in-memory computation device, according to one embodiment;
- Figure 2 shows a detailed circuit diagram of a portion of the device of Figure 1, according to one embodiment;

- Figure 3 shows a flowchart of a calibration method of the device of Figure 1, according to one embodiment; and
- Figure 4 shows a portion of the IMC device of Figure 1, in use, during the calibration step.

### Description of Embodiments

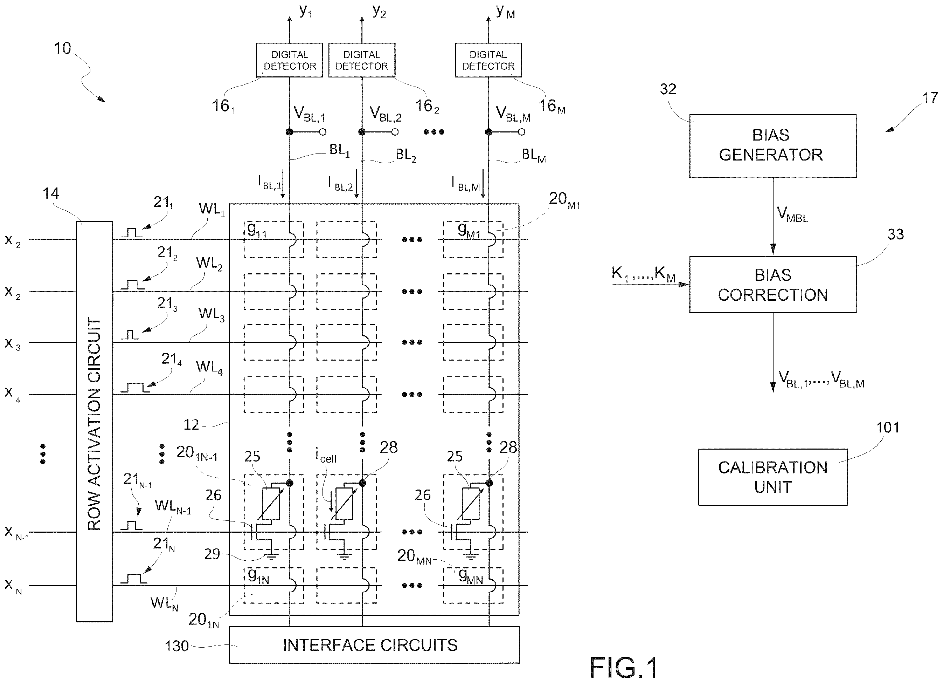

Figure 1 shows an in-memory computation device (hereinafter IMC device) 10 comprising a computation memory array (hereinafter referred to for simplicity only as memory array or computation array) 12; a row activation unit or circuit 14; an output detection circuit, herein comprising a plurality of digital detectors 16₁, ..., 16_{M}; and a bias circuit 17.

The memory array 12 comprises a plurality of memory cells 20 organized according to a matrix arrangement having M columns and N rows.

In the following, a generic memory cell of the plurality of memory cells 20 is identified by 20ᵢⱼ, wherein the indices i=1, ..., M and j=1, ..., N indicate the column and, respectively, the row of the generic memory cell 20ᵢⱼ in the memory array 12.

The memory cells 20 that are arranged in a same column i of the memory array 12 are mutually connected through a respective bit line BLᵢ, where i=1,..., M. The memory cells 20 arranged in the same row j of the memory array 12 are mutually connected through a respective word line WLⱼ, where j=1,...,N.

The row activation unit 14, hereinafter also referred to as the word line activation circuit, is configured to provide a plurality of activation signals 21₁,...,21_{N} to the word lines WL₁, ..., WL_{N}, in particular a respective signal 21ⱼ for each word line WLⱼ.

The activation signals 21₁,...,21_{N} are configured to activate each of the memory cells 20₁ⱼ,...,20_{Mj} that are coupled to the respective word line WLⱼ.

The row activation unit 14 receives an input signal X including a plurality of input values x₁,...,x_{N} one for each word line WLⱼ.

The input signal X may be indicative of the input values of an in-memory operation or of the calibration input values to be used during a calibration operation of the IMC device 10, as discussed in detail below.

The activation signals 21₁,...,21_{N} each have a respective duration Tⱼ that is a function of the respective input value xⱼ.

In detail, each activation signal 21ⱼ is configured to activate the respective memory cells 20₁ⱼ,...,20_{Mj} coupled to the respective word line WLⱼ for the duration Tⱼ.

The duration Tⱼ may be a linear or non-linear function of the respective input value xⱼ, for example of the respective sign and/or absolute value, depending on the specific implementation. In particular, the duration Tⱼ may be proportional to the absolute value of the input value xⱼ.

For example, the activation signals 21₁,...,21_{N} may be pulses, in particular rectangular pulses, each having a time width that is a function of, in particular equal to, the duration Tⱼ.

The memory cells 20 are programmed to each store a respective computational weight wᵢⱼ that may be used as a weight in the execution of an in-memory operation such as for example a Multiply and Accumulate (MAC) operation.

In this embodiment, the memory cells 20 are of the non-volatile type.

The memory cells 20 may each comprise one or more storage elements, depending on the specific implementation and the specific mapping of the computational weights in the memory array 12.

In detail, each memory cell 20ᵢⱼ is a cell with variable (i.e., programmable) resistivity, configured to have a conductance value gᵢⱼ that depends on the respective computational weight wᵢⱼ based on the specific mapping function used to map the computational weights in the memory array 12. Therefore, in the following, the references gᵢⱼ and wᵢⱼ may be used indistinctly to refer to the computational weight stored in the memory cell 20ᵢⱼ or the electrical quantity corresponding to the respective computational weight.

In the embodiment of Figure 1, the memory cells 20 each comprise for example a storage element 25 and a selection element 26.

The storage element 25 of each memory cell 20 is a variable resistive element, in particular here based on a Phase Change Material (PCM), such as for example a chalcogenide.

In detail, the computational weight wᵢⱼ indicates the transconductance value gᵢⱼ of the storage element 25 of the respective memory cell 20, i.e. it is indicative of the programmed resistance of the storage element 25.

For example, in the specific case of memory cells based on PCM technology, the phase change material has at least two phase states, for example an amorphous phase and a crystalline phase, each having a respective resistivity.

A phase change material may be transformed from a phase state to another by heat transfer, for example using current pulses.

The resistance of each storage element 25 associated with the respective phase state is used to distinguish two or more logic states of the corresponding memory cell 20.

For example, the amorphous phase may have a higher resistance than the crystalline phase. A logic state '0', or reset state, may be associated with the amorphous phase of the storage element 25. A logic state '1', or set state, may be associated with the crystalline phase of the storage element 25.

The storage element 25 has a first terminal coupled to a node 28 of the respective bit line BLᵢ and a second terminal coupled to a reference potential node, here to ground 29, through the selection element 26.

The selection element 26 is a switch, for example a BJT transistor, a diode or a MOS transistor, here an NMOS transistor, which is arranged in series with the respective storage element 25 and whose switching is controlled by the activation signal 21ⱼ of the respective word line WLⱼ.

In this embodiment, the NMOS transistor forming the selection element 26 has a source coupled, here directly connected, to ground 29; a drain coupled, here directly connected, to the second terminal of the storage element 25; and a gate coupled, here directly connected, to the respective word line WLⱼ.

In practice, the storage element 25 and the selection element 26 form a current path of the respective memory cell 20; the selection element 26, in response to receiving the respective activation signal 21ⱼ, closes the respective current path, thereby allowing a cell current i_{cell} to flow from the common node 28 to ground 29.

The memory cells 20ᵢ₁, ..., 20_{iN} are coupled to the bit line BLᵢ in such a way that the bit line current I_{BL, i} that flows through the bit line BLᵢ is a function of, in particular equal to, the sum of the cell currents i_{cell} of the memory cells 20ᵢ₁,...,20_{iN}.

The digital detectors 16₁, ..., 16_{M} are analog-to-digital converters (ADCs) that are each coupled to a respective bit line BLᵢ and each provide an output signal yᵢ in response to sampling the current I_{BL, i} that flows through the respective bit line BLᵢ.

In detail, the digital detectors 16₁,...,16_{M} are each configured to perform a time integral of the respective current I_{BL, i} and thus measure the charge Q_{BL, i} flowed in the bit line BLᵢ during a computation interval.

The bias circuit 17 is configured to provide, to each bit line BLᵢ, a respective corrected bias voltage V_{BL, i} that is a function of a common bias signal and a calibration factor Kᵢ associated with the bit line BLᵢ.

The following description refers to the embodiment wherein the common bias signal is a common bias voltage V_{MBL}; this may allow to simplify the design and implementation of the bias circuit 17. However, the common bias signal may be a voltage obtained directly or indirectly, for example by processing a current or another type of signal).

The calibration factor Kᵢ is indicative of an error between an actual charge Q_{eff,i} and an ideal charge Q_{idl,i} that has been measured during a calibration step of the IMC device 10, as discussed in detail below.

In other words, as discussed in detail below, the calibration factor Kᵢ is representative of an error between an actual computational result and an ideal computational result of the calibration step of the IMC device 10.

The corrected bias voltage V_{BL,i} may be a function of the product of the common bias voltage V_{MBL} and the respective calibration factor Kᵢ; in particular, V_{BL, i}=Kᵢ ·V_{MBL}. This may further simplify the design of the bias circuit 17.

The calibration factors K₁,...,K_{M} are determined during a calibration step of the IMC device 10, as discussed in detail below.

In detail, the bias circuit 17 comprises a bias generator 32 that generates the common bias voltage V_{MBL}, and a correction circuit 33 that generates the bias voltages V_{BL,1},...,V_{BL,M} starting from the common bias voltage V_{MBL} and the calibration factors K₁,...,K_{M}.

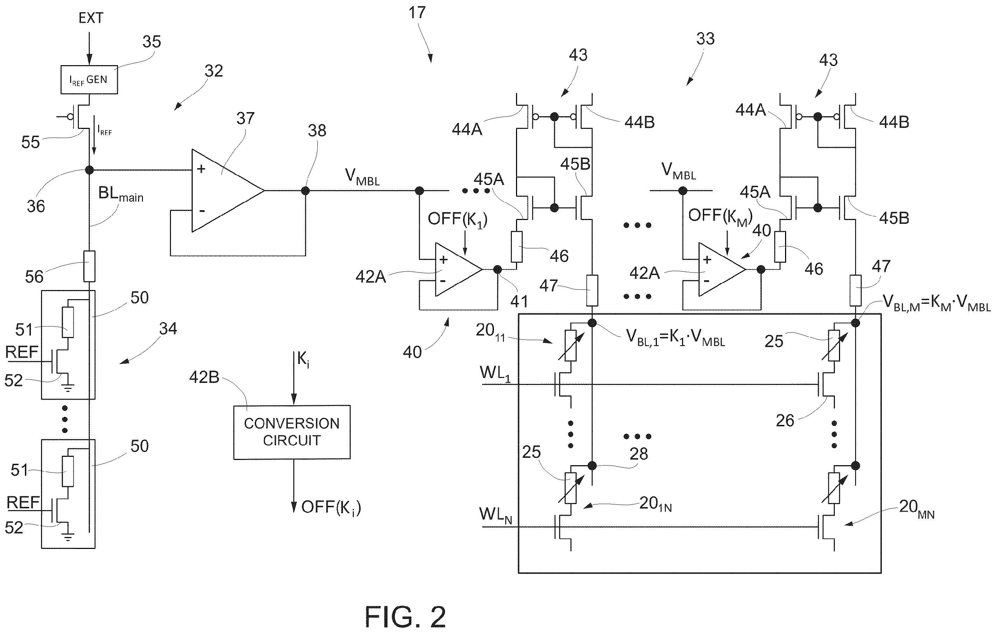

According to the detailed embodiment of Figure 2, the bias generator 32 generates the bias voltage V_{MBL} as a function of a reference current I_{REF} and a reference network 34 having a reference impedance Z_{REF}. This allows to obtain high versatility in generating the common bias voltage V_{MBL}.

In detail, the bias generator 32 comprises a current source 35 that generates the reference current I_{REF}.

The bias circuit 17 may be configured to modify the reference current I_{REF}. This allows to increase the versatility in adapting the bias circuit 17 to different applications.

In particular, the current source 35 is a controllable current source that receives an external signal EXT, for example from a user of the IMC device 10, that is indicative of a desired value of the reference current I_{REF}.

The reference network 34 receives the reference current I_{REF} at an input node 36.

The input node 36 is therefore at a voltage that is a function of the reference current I_{REF} and the reference impedance Z_{REF}.

The voltage at the input node 36 corresponds to the common bias voltage V_{MBL}.

The generator 32 may further comprise a voltage distribution circuit, here formed by an operational amplifier 37 having an output 38, which is in a voltage follower configuration and provides the common bias voltage V_{MBL} to the correction circuit 33.

The correction circuit 33 comprises, for each bit line BLᵢ, a respective trimming circuit 40 that receives the common bias voltage V_{MBL} and provides at output the corrected bias voltage V_{BL,i}. In particular, the corrected bias voltage V_{BL,i} may be a function of a product between the common bias voltage V_{MBL} and the respective calibration factor Ki, this allows to obtain analog compensation in a simple and effective manner.

In particular, the corrected bias voltage V_{BL, i} may be equal to Kᵢ·V_{MBL}.

In the embodiment of Figure 2, the trimming circuit 40 comprises an operational amplifier 42A in a voltage follower configuration having an adjustable offset OFF(Kᵢ) that depends on the respective calibration factor Kᵢ, in such a way that the respective output 41 is at the voltage Kᵢ·V_{MBL}. In detail, the trimming circuit 40 of each bit line BLᵢ also comprises a respective conversion circuit 42B that receives the calibration factor Kᵢ and provides at output the offset OFF(Kᵢ) to the respective amplifier 42A.

In practice, the corrected bias voltage V_{BL,i} of each bit line BLᵢ may be a voltage adjustable in the neighbourhood V_{MBL}±Δᵢi where Δᵢ depends on the respective calibration factor Kᵢ.

The correction circuit 33 may further comprise, for each bit line BLᵢ, a voltage distribution circuit 43 configured to apply the bias voltage V_{BL, i} to the respective bit line BLᵢ.

Each voltage distribution circuit 43 may comprise one or more switches, for example MOSFET transistors, configured to operate as a current mirror. In particular, each voltage distribution circuit 43 may comprise two PMOS transistors 44A, 44B, whose gate terminals are directly connected to each other, and two NMOS transistors 45A, 45B, whose gate terminals are directly connected to each other. Furthermore, the transistors 44B and 45A are each in the diode-connected configuration.

Transistors 44A, 45A are series-coupled with each other and are coupled to the output 41 of the trimming circuit 40 through a circuit 46.

Transistors 44B, 45B are series-coupled with each other on the respective bit line BLᵢ.

Each bit line BLᵢ may also comprise a respective selection circuit 47, such as a switch, configured to operate as a column decoder to select whether or not to use the bit line BLᵢ during the execution of a memory operation. For example, the selection circuit 47 may be used to couple or decouple the respective bit line BLᵢ from the digital detector 16ᵢ, depending on whether or not the bit line BLᵢ is used for the execution of an in-memory operation.

The circuit 46 is configured to compensate for the voltage drop caused by the selector circuit 47, regardless of the current that flows along the main bit line BLₘₐᵢₙ, thus forcing the voltage of the main bit line to the value at the output of the regulator (node 41). In other words, the upstream node of the circuit 47 is forced to the value of the node 41, with the circuits 46 and 47 that generate (substantially) the same voltage drop, allowing (substantially) to have the same potential at the source terminals of the transistors 45A and 45B.

According to one embodiment, as shown in Figure 2, the reference network 34 is formed by a dedicated memory array, hereinafter also referred to as reference memory array or simply reference array and indicated by the numeral 34, having an overall reference transconductance value g_{ref} and comprising one or more reference memory cells, here a plurality of reference cells 50.

The reference cells 50 are non-volatile memory cells.

The reference memory array 34 may be a portion of the memory array 12 or may be a separate memory array.

The reference cells 50 have the same circuit configuration as the memory cells 20 of the memory array 12.

In detail, the reference cells 50 each comprise one or more storage elements 51 and a selection element 52, in particular equal to the storage element 25 and, respectively, to the selection element 26 of the memory cells 20.

In practice, the storage element 51 is based on the same technology used to provide the storage element 25. For example, if the storage element 25 is based on a PCM material, then the storage element 51 is also based on a PCM material, in particular the same PCM material.

The reference cells 50 are programmed to store respective reference transconductance values, that may be equal to or different from each other, depending on the specific application.

The number of reference cells 50 and the respective reference transconductance values may be chosen, during the design step, so that the reference memory array 34 is a statistically significant sample of the memory array 12.

In practice, the overall reference transconductance value g_{ref} of the reference memory array 34 statistically represents an overall transconductance of the memory array 12.

For example, the overall transconductance of the memory array 34 may be equal to the transconductance that the memory array 12 would have if a set of the memory cells 20, for example all the memory cells of the array 12 or all the memory cells coupled to a same bit line BLᵢ, were activated simultaneously.

For example, the reference cells 50 may be programmed so that the overall reference transconductance g_{ref} of the reference memory array 33 is equal to an average value of the overall transconductance of the memory array 12.

For example, the average value may represent the average transconductance value that the memory array 12 has in use, for example as determined during a calibration or initialization step of the IMC device 10.

In particular, in the embodiment of Figure 2, the memory cells 50 are coupled to a same main bit line BLₘₐᵢₙ. For example, the reference array 34 may comprise a number N of memory cells 50, arranged on N word lines.

In detail, the storage elements 51 may have a first terminal that is coupled to the input node 36 of the reference network 34 and a second terminal coupled to a reference potential node, here at ground, through the selection element 52.

In practice, the reference cells 50 all share the same main bit line BLₘₐᵢₙ.

The selection elements 52 may each be formed by a respective switch, for example a BJT transistor, a diode or a MOSFET transistor, here an NMOS transistor, in particular equal to the selection element 26 of the memory cells 20, that is arranged in series with the respective storage element 51.

In this embodiment, the selection elements 52 of all the reference cells 50 are controlled by a same reference activation signal REF, that for example may be generated by the word line activation unit 14 or by other components of the IMC device 10, not shown here.

However, the selection elements 52 may each be controlled by a respective reference activation signal, different from each other, for example depending on which reference cells 50 are intended to be activated, during a computation of the IMC device 10.

In practice, in the embodiment of Figure 2, the reference impedance Z_{REF} is a function of the transconductance values g_{ref} stored by the reference cells 50 and of the reference activation signal REF, i.e. it is a function of the number of cells 50 activated by the reference signal REF and of the resistance of the storage elements 51 of the cells 50 activated by the reference signal REF.

The bias generator 32 may also comprise further circuit elements, coupled to the main bit line BLₘₐᵢₙ, useful for controlling the bias generator 32. In particular, in the embodiment of Figure 2, a switch (e.g., a MOSFET transistor 55) configured to select the specific current source 35, this may be useful for example in case the bias generator 32 comprises a plurality of current sources, in such a way as to be able to select the desired reference current I_{REF}; and/or a column selector 56, for example comprising one or more transistors, configured to select the set of memory cells 50 to be used for generating the common bias voltage V_{MBL}, this may be useful for example to select the specific bit line to be used as the main bit line for generating the common bias voltage V_{MBL} in case the input node 36 is couplable to a plurality of bit lines, in such a way as to be able to select the desired reference impedance Z_{REF}.

In use, during the execution of an in-memory operation such as a MAC operation, the memory cells 20₁ⱼ,...,20_{Mj} are activated for the activation duration Tⱼ. Furthermore, the bias circuit 17 provides the bit lines BL₁,...,BL_{M} with the respective bias voltages V_{BL,1},...,V_{BL,M}.

Thus, in use, the cell current i_{cell} of each memory cell 20ᵢⱼ depends on the transconductance value gᵢⱼ stored in the respective storage element 25, on the activation duration Tⱼ and on the bias voltage V_{BL, i}.

In detail, the absolute value of each cell current i_{cell} depends on the respective transconductance value gᵢⱼ (and also on the value of the corrected bias voltage V_{BL,i}, as discussed in detail below) and the time duration of each cell current i_{cell} depends on the respective activation time Tⱼ.

Consequently, an electric charge that is a function of the respective transconductance value gᵢⱼ and of the respective activation time Tⱼ is associated with each cell current i_{cell}.

Since the length of the pulse of the word line activation signals 21 is a function of the respective input value xⱼ, the electric charge associated with each cell current i_{cell} is a function of the product gᵢⱼ·xⱼ.

For each bit line BLᵢ, the respective bit line current I_{BL, i} is a sum of the cell currents i_{cell}. Therefore, the total electric charge associated with each bit line current I_{BL,i} is a function of the multiply and accumulate operation gᵢ₁·x₁ + gᵢ₂·x₂ + ... + g_{iN}·x_{N}.

Consequently, each output signal yᵢ, obtained by measuring the respective bit line current I_{BL, i}, in particular by integrating over time the respective bit line current I_{BL, i}, is indicative of the MAC operation gᵢ₁ · x₁ + gᵢ₂ ·x₂ + ... + g_{iN} · x_{N}.

Furthermore, the absolute value of each cell current i_{cell}, and thus also of each bit line current I_{BL, i}, also depends on the respective corrected bias voltage V_{BL, i}.

Thus, the fact that each corrected bias voltage V_{BL,i} depends on the calibration factor Kᵢ associated with the respective bit line BLᵢ allows, during the execution of the memory operation, to compensate in an analog way for any deviation of the memory cells 20 from the expected behavior, for example caused by a drift of the transconductance values gᵢⱼ.

In other words, the fact that the bias voltage V_{BL,i} is a function of the calibration factor Kᵢ allows to obtain an analog compensation of the calibration error and therefore avoid the execution of digital compensations on the output signal yᵢ.

Thus, the IMC device 10 may have both a high calculation precision and a low area occupation and a low energy consumption. In fact, the compensation may be obtained by reusing components already present in the IMC device 10.

Furthermore, compared to known approaches wherein the compensation is performed digitally on the output signal, the IMC device 10 allows to reduce the overall multiplication time since the steps of actual multiplication and scaling of the bitline values are parallelized. Conversely, in the digital approach, those two operations are performed in two distinct and sequential steps, lengthening the overall times.

Furthermore, in case the common bias voltage V_{MBL} is generated as a function of the reference impedance Z_{REF} of the set of reference cells 50 that represent a statistical sample of the memory cells 20, the calculation precision of the IMC device 10 may be further increased.

In particular, the use of the calibration factors Kᵢ, in combination with the generation of the common bias voltage V_{MBL} starting from the reference cells 50, allows to obtain a high compensation of any drifts undergone by the memory cells 20.

In fact, during the life of the IMC device 10, the IMC device 10 may be subject to phenomena, such as for example temperature variations, that may influence the transconductance values gᵢⱼ of the memory cells 20. Furthermore, the transconductance values gᵢⱼ of the memory cells 20 may be subject to drift; for example, in case the memory cells 20 are PCM memory cells, the storage elements 25 may be subject to aging phenomena such as for example amorphization.

Such deviations of the transconductance values gᵢⱼ from the programmed values may vary the bit line current I_{BL,i}, thereby causing errors in the output signal yᵢ.

In the IMC device 10, such temperature variations or drifts would also influence, similarly, the reference transconductance values of the reference memory cells 50, and, consequently, the overall reference transconductance value g_{ref} of the reference memory array 34, since the reference memory cells 50 represent a statistically significant sample of the memory cells 20.

A variation in the reference transconductance values of the reference memory cells 50 would cause a variation in the reference impedance Z_{REF} and, therefore, a variation in the voltage at the input node 36 of the reference network 34. Consequently, the common bias voltage V_{MBL} also varies.

In detail, the variation of the bias voltage V_{MBL} may compensate for the variation of the transconductance values gᵢⱼ of the memory cells 20.

For example, if the memory cells 20 undergo a drift that causes an increase in the respective transconductance values gᵢⱼ, the corresponding bit line current I_{BL,i} would also increase. At the same time, the overall reference transconductance value g_{ref} of the reference memory array 34 would also increase, thus causing a decrease in the reference impedance Z_{REF} and, consequently, in the common bias voltage V_{MBL}.

Assuming that the calibration factors Kᵢ are maintained constant, a decrease in the common bias voltage V_{MBL} causes a decrease in the bit line current I_{BL, i}.

Thus, the use of the reference array 34, in combination with the use of the calibration factor Kᵢ, allows to further improve the compensation of the variation in the bit line currents I_{BL,i} caused by the drift of the transconductance values gᵢⱼ.

In fact, the generation of the common bias voltage V_{MBL} starting from the reference array 34 allows to compensate for first-order variations due for example to drift (e.g., caused by temperature variations), while the correction described above through the calibration factor Kᵢ allows to obtain a second-order compensation on the individual bit lines. In other words, the common bias voltage V_{MBL} (given by the reference sector) compensates in a fixed manner for the variation on all sectors (for example, the average variation value on the reference sector is taken), while with the trimming circuit 40 a fine-tuning of the residual error may be performed on the single bit line.

Furthermore, the calibration that leads to obtaining the calibration factors Kᵢ may be done periodically.

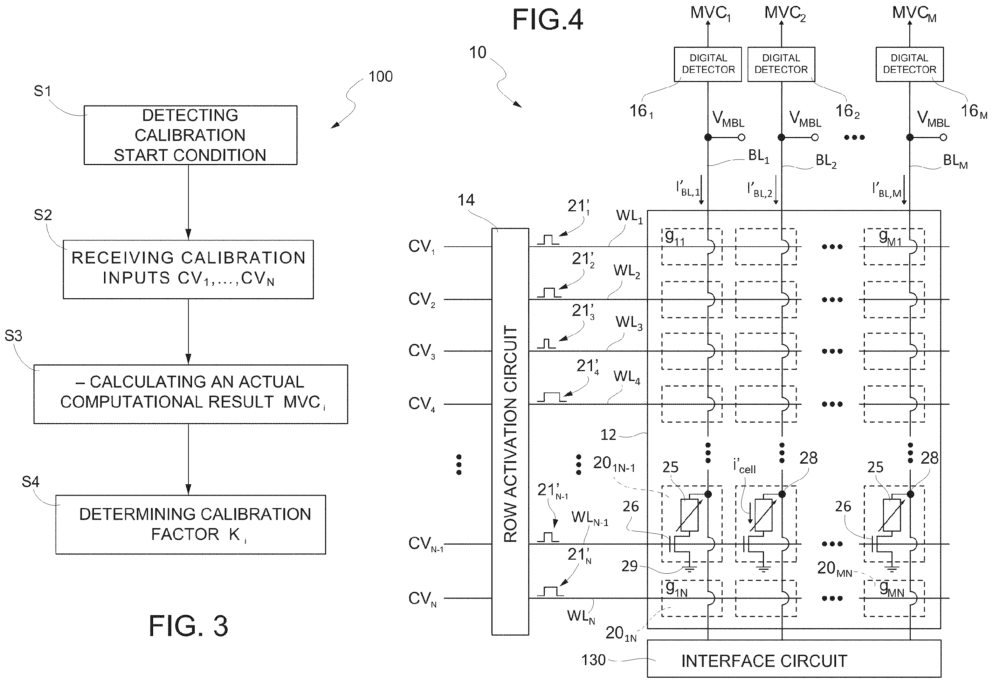

Hereinafter, a calibration method 100 is described, with reference to the flowchart of Figure 3, performed during a calibration step of the IMC device 10, wherein the calibration factors Kᵢ to be used during the execution of an in-memory operation are determined.

Furthermore, Figure 4 shows a portion of the IMC device 10 of Figure 1, in use during the calibration step.

The method 100 of the calibration step is performed by a calibration circuitry comprising the word line activation circuit 14, the bias circuit 17 and the digital detectors 16₁,...,16_{M}. The calibration circuitry may also comprise a calibration unit 101, including for example one or more memories and one or more processing units, useful for the execution of the calibration step.

The calibration method is performed after programming the memory array 12, i.e. after the computational weights wᵢⱼ have been mapped into the memory array 12. In other words, after the transconductance values gᵢⱼ have been written in the memory cells 20.

At a step S1, a calibration start condition is detected indicative of the need to perform a new calibration. The fact that the calibration is performed only in response allows to optimize the number and frequency of the calibration steps.

In detail, the IMC device 10 may be configured to receive a signal indicative of a calibration request from an external user, for example at a first use of the IMC device 10 or before starting a new computation of an in-memory operation or at each boot of the IMC 10 device.

In addition or alternatively, the IMC device 10 may be configured to automatically detect the calibration start condition.

For example, the calibration circuitry may be configured to monitor one or more parameters indicative of a possible drift of the memory cells 20; in particular, the calibration unit 101 may be configured to monitor, for example through dedicated sensors, the temperature of the IMC device 10 and/or one or more voltage or current values of the IMC device 10.

In addition or alternatively, the calibration start condition may be a time-based condition; i.e., the calibration unit 101 may be configured to periodically perform a new calibration as a function of a time distance from a preceding calibration step, for example at time intervals (that are fixed or variable) that may be chosen by a user in an initialization step of the IMC device 10.

At a step S2, the word line activation circuit 14 receives a plurality of calibration inputs CV₁,...,CV_{N}, one for each word line WLⱼ.

The calibration inputs CV₁,...,CV_{N} each indicate a respective calibration input value.

The calibration inputs CV₁,...,CV_{N} may be equal to or different from each other, depending on the specific implementation; for example, the calibration inputs CV₁,...,CV_{N} may be chosen by a user of the IMC device 10 during an initialization step of the IMC device 10.

Successively, step S3, the IMC device 10 calculates, for each bit line BLᵢ, a respective actual computational result MVCᵢ as a function of the computational weights stored in the respective bit line BLᵢ and calibration input values CV₁,...,CV_{N}.

In other words, the IMC device 10 performs a MAC operation, using the calibration inputs CV₁,...,CV_{N} as input values of the MAC operation.

In detail, at step S3, the word line activation circuit 14 provides calibration activation signals 21'₁,...,21'_{N} each as a function of a respective calibration input value CV₁,...,CV_{N}.

In case successive iterations of the calibration method 100 are performed, each iteration may use the same calibration input values CV₁,...,CV_{N}. In this way, it is possible to update the calibration factors Kᵢ through periodic iterations of the calibration method.

The calibration input values CV₁,...,CV_{N} may be determined by a user during an initialization step of the IMC device 10.

The calibration input values CV₁,...,CV_{N} may be stored in the IMC device 10, for example in a non-volatile (e.g., digital) memory of the IMC device 10, or may be provided to the IMC device 10 at the beginning of the calibration step, depending on the specific implementation.

In practice, during the calibration step, the input values x₁,...,x_{N} that the word line activation circuit 14 converts into the activation signals 21₁, ..., 21_{N}, as described above with reference to Figure 1, each correspond to a respective calibration input value CV₁, ..., CV_{N}.

Thus, the activation durations T₁,...,T_{N} of the calibration activation signals 21'₁, ..., 21'_{N} are a function of the calibration input values CV₁, ..., CV_{N}, similarly to what has been discussed above for the input values x₁,...,x_{N}.

During step S3 of the calibration step, the bias circuit 17 provides the bit lines BL₁,...,BL_{M} with a voltage that depends on the common bias voltage V_{MBL}.

For example, during a first iteration of the calibration step, the bias circuit 17 provides the same bias voltage to all bit lines BL₁,...,BL_{M}.

In particular, the bias circuit 17 may provide the common bias voltage V_{MBL} to all bit lines BL₁,...,BL_{M} or a voltage derived from the common voltage V_{MBL}.

In practice, at step S3 of the method 100, the calibration factors K₁,...,K_{M} may be equal to each other and in particular equal to 1.

However, at a generic iteration p of the calibration step, the bias circuit 17 may be configured to provide, to each bit line BLᵢ, a calibration bias voltage that depends on the common bias voltage V_{MBL} and on the respective calibration factor Kᵢ(p-1) that has been determined in the preceding calibration iteration p-1; in particular, as a function of V_{MBL}·Kᵢ(p-1). In this way, through periodic repetitions of the calibration, it is possible to follow (and compensate for) any further drifts of the memory cells 20 and therefore increase the calculation precision of the IMC device 10.

The digital detectors 16₁, ..., 16_{M} detect the actual computational results MVC₁,...,MVC_{M} each as a function of the respective bit line current I'_{BL,1},...,I'_{BL,M} that flows during the calibration step.

The actual computational results MVC₁,...,MVC_{M} are each indicative of the respective actual charge Q_{eff,i} that flows in the bit line BLᵢ during step S3.

In practice, during the calibration method 100, the output signals y₁,...,y_{M} each correspond to a respective actual calibration computation result MVC₁,...,MVC_{M}.

Each actual calibration result MVCᵢ is therefore indicative of the operation ${\sum }_{j = 1}^{N} {w}_{ij} ⋅ {CV}_{j}$, where wᵢⱼ is the actual computational weight programmed in the memory cell 20ᵢⱼ.

Then, step S4, the calibration unit 101 determines each calibration factor Kᵢ as a function of an error between the respective actual computational result MVCᵢ and a respective ideal computational result MVIᵢ.

Each ideal calibration result MVIᵢ is indicative of the ideal charge Q_{idl,i} that would have flowed in the bit line BLᵢ in step S3, if the transconductance values stored in the memory cells 20i₁,..,20_{iN} corresponded (i.e., were equal) to the nominal transconductance values that were intended to be programmed during the programming of the memory array 12.

In practice, each ideal calibration result MVIᵢ is indicative of the operation ${\sum }_{j = 1}^{N} {w}_{ij , id} ⋅ {CV}_{j}$, wherein w_{ij,id} is the nominal computational weight that was intended to be programmed in the memory cell 20ᵢⱼ.

The ideal calibration results MVIᵢ may be stored in a dedicated memory of the calibration unit 101.

In detail, each calibration factor Kᵢ may be a function of a ratio between the actual calibration result MVCᵢ and the respective ideal calibration result MVIᵢ; in particular, it may be Kᵢ=MVCᵢ/MVIᵢ. This allows to obtain the analog compensation discussed above in a simple and effective way.

The calibration unit 101 stores the calibration factors K₁,...,K_{M} in a dedicated memory, in such a way that they may be provided to the bias correction circuit 33 during the execution of a memory operation.

The actual computational weight wᵢⱼ programmed in the memory cell 20ᵢⱼ may be subject to drift phenomena during the life of the IMC device 10 and thus be different from the nominal computational weight w_{ij,id} programmed in the cell 20ᵢⱼ during the programming of the memory array 12.

Thus, in practice, each calibration factor Kᵢ is indicative of an error between the actual values wᵢ₁,...,w_{iN} and the nominal values w_{il,id},...,w_{iN,id} of the computational weights of the memory cells 20ᵢₗ,...,20_{iN} coupled to the bit line BLᵢ.

The calibration method 100 allows to obtain a measurement indicative of the deviation of the computational weights from the respective nominal value in a simple and efficient manner.

As previously discussed, the calibration factors Kᵢ thus determined may be used to compensate in an analog way such deviations during the execution of in-memory operations.

According to an embodiment, the calibration step may also comprise, by the calibration unit 101 and/or the bias circuit 17, modifying at least one of the reference current I_{REF} and the reference impedance Z_{REF}, in particular before step S2 of Figure 2.

This allows to compensate for any anomalous bit lines for which compensation of the bias voltage in the neighbourhood V_{MBL}±Δᵢ would not be sufficient. Modifying one or more of the reference current I_{REF} and the reference impedance Z_{REF} allows to change the configuration of the reference sector 34 and therefore change the value of the common bias voltage V_{MBL}, in this way it is possible to get as close as possible to the target correction value for such anomalous bit lines. In essence, this also allows to compensate for exceptional cases wherein there is a very accentuated drift only of some columns that cannot be compensated for by the average value of the reference sector and by the successive fine-tuning.

Finally, it is clear that modifications and variations may be made to what has been described above without thereby departing from the scope of the present invention, as defined in the attached claims.

For example, the trimming circuit 40 of each bit line BLᵢ may provide the respective corrected bias voltage V_{BL, i} as a function of the common bias voltage V_{MBL} and the calibration factor Kᵢ and, depending on the specific implementation, comprise circuit elements other than the operational amplifier 42A and/or the conversion circuit 42B.

In the description hereinabove, reference has been made to the conductance (or transconductance) of the memory cells; however, it will be clear to the person skilled in the art that the conductance (gᵢⱼ or g_{ref}) may equivalently be a resistance or another electrical quantity, depending on the specific implementation and the specific technology on which the memory cells are based.

The memory cells 20 may be resistive memory cells not based on PCM materials, but on different technologies; for example, they may be magnetoresistive (MRAM), resistive (RRAM) or static (SRAM) memory cells.

The storage element 25 of each memory cell 20 may be formed by a plurality of selectable resistive elements, equal to or different from each other, mutually arranged in parallel, for example between the respective bit line and ground, that may be selectively enabled or disabled during the programming of the memory array 12, so that the respective transconductance value gᵢⱼ may be a multibit value.

For example, the reference impedance Z_{REF} of the reference network 34 of Figure 2 may be a variable impedance, for example controllable by a user in response to a drift of the memory cells 20, achieved in a different manner from what has been shown, i.e., it may not comprise the reference memory cells 50.

The IMC device may also comprise further circuits, units, blocks, etc., for example interface circuits 130, that may be useful in operating the IMC device during the programming of the memory arrays 12, 34 and/or during the execution of an in-memory operation, such as for example programming circuits, row and/or column selection circuits, etc.

For example, the output detection circuit of the IMC device may also comprise circuits, blocks, units or modules, for example one or more digital signal processors (DSPs), configured to process the output signals provided by the digital detectors.

The output detection circuit may comprise a different number of digital detectors; for example, each digital detector may be configured to be coupled to a plurality of bit lines. In such a case, the IMC device may also comprise one or more column selection circuits configured to adjust the coupling between digital detectors and bit lines, depending on the specific application and implementation.

The calibration step may be performed by a dedicated calibration circuitry of the IMC device or external to the IMC device, depending on the specific application.

It will be clear to the person skilled in the art that the described invention may apply to each, one or more, of the bit lines BLᵢ, i.e., what is described may refer to one or more of the output signals y₁,...,y_{M} wherein each represents the vector-matrix multiplication associated with the respective bit line BLᵢ.

Finally, the different embodiments described above may be combined to provide further solutions.

According to what has been described above, an in-memory computation, IMC, device may be summarized by the following examples.

Example 1. An in-memory computation, IMC, device comprising:
a word line activation circuit (14) configured to receive a plurality of input values (x₁,...,x_{N}) and, in response, to provide a plurality of activation signals (21₁,...,21_{N}) to a plurality of word lines (WL₁,...,WL_{N}), as a function of the plurality of input values;
a bias circuit (17) configured to provide a corrected bias voltage (V_{BL,i}) to a bit line (BLᵢ);
a computation memory array (12) comprising a plurality of memory cells (20ᵢ₁,...,.20_{iN}) couplable to the bit line (BLᵢ) and each couplable to a respective word line (WLⱼ) of the plurality of word lines, the memory cells being configured to each store a respective computational weight (wᵢⱼ) and to each receive a respective activation signal (21j), the memory cells being configured to each be traversed by a respective cell current (i_{cell}) that is a function of the corrected bias voltage, the respective activation signal and the respective computational weight, the bit line being configured to be traversed by a bit line current (I_{BL,i}) that is a function of a sum of the cell currents; and
an output detection circuit (16ᵢ) couplable to the bit line (BLᵢ) and configured to provide, as a function of the bit line current (I_{BLi}), an output signal (yᵢ) indicative of a charge flowed in the bit line (BLᵢ),
wherein the corrected bias voltage (V_{BL,i}) is a function of a common bias signal (V_{MBL}) and a calibration factor (Kᵢ), the calibration factor (Kᵢ) being determined during a calibration step of the IMC device and being representative of an error between an actual computational result (MVCᵢ) and an ideal computational result (MVIᵢ) of the calibration step.

Example 2. The IMC device according to the preceding example, wherein the bias circuit comprises a correction circuit (33) configured to provide the corrected bias voltage (V_{BL,i}) as a function of a multiplication between the calibration factor (Kᵢ) and the common bias signal (V_{MBL}).

Example 3. The IMC device according to any of examples 1 or 2, wherein the common bias signal is a common bias voltage (V_{MBL}), the bias circuit being configured to generate the common bias voltage as a function of a reference current (I_{REF}) and a reference impedance (Z_{REF}), and, optionally, wherein the bias circuit is configured to modify at least one of the reference current and the reference impedance.

Example 4. The IMC device according to example 3, wherein the bias circuit comprises a reference memory array (34) comprising a plurality of reference memory cells (50) and configured to have a reference transconductance value (g_{ref}), the reference impedance being a function of the reference transconductance value.

Example 5. The IMC device according to the preceding example, wherein the reference memory cells (50) represent a statistically significant sample of the memory cells (20) of the computation memory array (12).

Example 6. The IMC device according to any of the preceding examples, wherein the memory cells (20) each comprise a current path that extends between a common node (28) of the bit line (BLᵢ) and a reference node (29) and comprises one or more storage elements (25) and one or more selection elements (26), the selection element being configured to selectively close the respective current path, as a function of the respective activation signal.

Example 7. The IMC device according to any of the preceding examples, wherein the memory cells are non-volatile resistive memory cells, for example PCM memory cells.

## Claims

1. An in-memory computation, IMC, device (10) comprising:
a word line activation circuit (14) configured to receive a plurality of input values (x₁,...,x_{N}) and, in response, to provide a plurality of activation signals (21₁,..., 21_{N}) to a plurality of word lines (WL₁,...,WL_{N}), as a function of the plurality of input values;
a bias circuit (17) configured to provide a corrected bias voltage (V_{BL,i}) to a bit line (BLᵢ);
a computation memory array (12) comprising a plurality of memory cells (20ᵢ₁,...,.20_{iN}) couplable to the bit line (BLᵢ) and each couplable to a respective word line (WLⱼ) of the plurality of word lines, the memory cells being configured to each store a respective computational weight (wᵢⱼ) and to each receive a respective activation signal (21j), the memory cells being configured to each be traversed by a respective cell current (i_{cell}) that is a function of the corrected bias voltage, the respective activation signal and the respective computational weight, the bit line being configured to be traversed by a bit line current (I_{BL,i}) that is a function of a sum of the cell currents; and
an output detection circuit (16ᵢ) couplable to the bit line (BLᵢ) and configured to provide, as a function of the bit line current (I_{BLi}), an output signal (yᵢ) indicative of a charge flowed in the bit line (BLᵢ),
wherein the corrected bias voltage (V_{BL, i}) is a function of a common bias signal (V_{MBL}) and a calibration factor (Kᵢ), the calibration factor (Kᵢ) being determined during a calibration step of the IMC device and being representative of an error between an actual computational result (MVCᵢ) and an ideal computational result (MVIᵢ) of the calibration step.

2. The IMC device according to the preceding claim, wherein the bias circuit comprises a correction circuit (33) configured to provide the corrected bias voltage (V_{BL, j}) as a function of a multiplication between the calibration factor (Ki) and the common bias signal (V_{MBL}).

3. The IMC device according to any of the preceding claims, wherein the common bias signal is a common bias voltage (V_{MBL}), the bias circuit being configured to generate the common bias voltage as a function of a reference current (I_{REF}) and a reference impedance (Z_{REF}).

4. The IMC device according to claim 3, wherein the bias circuit is configured to modify at least one of the reference current and the reference impedance.

5. The IMC device according to claim 3 or 4, wherein the bias circuit comprises a reference memory array (34) comprising a plurality of reference memory cells (50) and configured to have a reference transconductance value (g_{ref}), the reference impedance being a function of the reference transconductance value.

6. The IMC device according to claim 5, wherein the reference memory cells (50) represent a statistically significant sample of the memory cells (20) of the computation memory array (12).

7. The IMC device according to any of the preceding claims, wherein the memory cells (20) each comprise a current path that extends between a common node (28) of the bit line (BLᵢ) and a reference node (29) and comprises one or more storage elements (25) and one or more selection elements (26), the selection element being configured to selectively close the respective current path, as a function of the respective activation signal.

8. The IMC device according to any of the preceding claims, wherein the memory cells are non-volatile resistive memory cells, for example PCM memory cells.

9. The IMC device according to any of the preceding claims, configured to perform the calibration step and further comprising a calibration circuitry (14, 16ᵢ, 17, 101) configured, during the calibration step, to:
receive a plurality of calibration input values (CV₁,...,CV_{N}) and, in response, to provide a plurality of calibration activation signals (21'₁,...,21'_{N}) to the word lines (WL₁, ..., WL_{N}), as a function of the plurality of the calibration input values; and
provide, to the bit line, a calibration bias voltage as a function of the common bias signal (V_{MBL}) and, optionally, also as a function of a calibration factor (Kᵢ(p-1)) determined in a preceding calibration step (p-1),
in such a way that the cell currents (i'_{cell}) of the memory cells (20) of the computation memory array are, during the calibration step, each a function of the calibration bias voltage, the respective computational weight and the respective calibration activation signal.

10. The IMC device according to claim 9, wherein the calibration circuitry is further configured to:
detect the actual computational result (MVCᵢ) as a function of the bit line current (I'_{BL,i}) that flows in the bit line during the calibration step, wherein the actual computational result is indicative of the charge flowed in the bit line; and
determine the calibration factor (Kᵢ) as a function of the error between the actual computational result and the ideal computational result (MVIᵢ), wherein the ideal computational result is indicative of the charge that would have flowed in the bit line (BLᵢ) during the calibration step in case the computational weights (wᵢⱼ) actually stored in the memory cells coupled to the bit line correspond to respective nominal computational weights (w'ᵢⱼ).

11. The IMC device according to any of the preceding claims, wherein the calibration factor (Kᵢ) is a function of a ratio between the actual computational result (MVCᵢ) and the ideal computational result (MVIᵢ).

12. The IMC device according to any of the preceding claims, wherein the calibration factor (Kᵢ) is indicative of an error between an actual value (wᵢⱼ) and a nominal value (w_{ij,id}) of the computational weights of the memory cells (20ᵢ₁,...,20_{iN}) coupled to the bit line (BLᵢ).

13. The IMC device according to any of the preceding claims, configured to perform the calibration step in response to the detection of a calibration condition, wherein the calibration condition is a function of one or more parameters indicative of a drift of the memory cells (20) of the computation memory array (12), for example a function of at least one of: a time distance from a preceding calibration step, a temperature of the IMC device, an external signal received from a user of the IMC device.

14. A method of controlling an in-memory computation, IMC, device (10) comprising a computation memory array (12) including a plurality of memory cells (20ᵢ₁,...,.20_{iN}) coupled to a bit line (BLᵢ) and a plurality of word lines (WL₁, ..., WL_{N}) and each storing a respective computational weight (wᵢⱼ),
the method comprising:
receiving a plurality of input values (x₁,...,x_{N}) and, in response, providing a plurality of activation signals (21₁,...,21_{N}) to the word lines (WL₁,...,WL_{N}) as a function of the plurality of input values;
providing a corrected bias voltage (V_{BL,i}) to the bit line;
providing, as a function of a bit line current (l_{BL,i}), an output signal (yᵢ) indicative of a charge flowed in the bit line (BLᵢ),
wherein the memory cells are configured to be each traversed by a respective cell current (i_{cell}) that is a function of the corrected bias voltage (V_{BL,i}), of the activation signal (21ⱼ) received from the respective word line (WLⱼ) and of the respective computational weight, and wherein the bit line current (I_{BL,i}) is a function of a sum of the cell currents of the memory cells coupled to the bit line,
wherein the corrected bias voltage is a function of a common bias signal (V_{MBL}) and of a calibration factor (Kᵢ), the calibration factor (Kᵢ) being determined during a calibration step of the IMC device and being representative of an error between an actual computational result (MVCᵢ) and an ideal computational result (MVIᵢ) of the calibration step.

15. A method of calibrating an in-memory computation, IMC, device (10) comprising a computation memory array (12) including a plurality of memory cells (20ᵢ₁,...,.20_{iN}) coupled to a bit line (BLᵢ) and a plurality of word lines (WL₁, ..., WL_{N}) and each storing a respective computational weight (wᵢⱼ),
the method comprising, during a calibration step, by a calibration circuitry (14, 16ᵢ, 17, 101):
receiving a plurality of calibration input values (CV₁,...,CV_{N}) and, in response, providing a plurality of calibration activation signals (21'₁,...,21'_{N}) to the word lines (WL₁,...,WL_{N}), as a function of the plurality of the calibration input values;
providing, to the bit line, a calibration bias voltage as a function of a common bias signal (V_{MBL});
detecting an actual computational result (MVCᵢ) as a function of a bit line current (I'_{BL,i}) that flows in the bit line during the calibration step, wherein the actual computational result is indicative of the charge flowed in the bit line during the calibration step,
wherein the memory cells are configured to each be traversed by a respective cell current (i_{cell}) that is a function of the calibration bias voltage (V_{MBL}), the calibration activation signal (21'ⱼ) received from the respective word line (WLⱼ) and the respective computational weight, and wherein the bit line current (I'_{BL,i}) is a function of a sum of the cell currents of the memory cells coupled to the bit line,
the method further comprising, by the calibration circuitry:
determining the calibration factor (Kᵢ) as a function of the error between the actual computational result and an ideal computational result (MVIi), wherein the ideal computational result is indicative of the charge that would have flowed in the bit line (BLᵢ) during the calibration step in case the computational weights (wᵢⱼ) actually stored in the memory cells coupled to the bit line correspond to respective nominal computational weights (w'ᵢⱼ).
